Europäisches Patentamt

**(19)** European Patent Office

Office européen des brevets

**(11)** Publication number : **0 323 172 B1**

# **(12)** EUROPEAN PATENT SPECIFICATION

**(45)** Date of publication of patent specification :
03.05.95 Bulletin 95/18

**(51)** Int. Cl.⁶ : **G11C 11/24,** G11C 7/00

**(21)** Application number : 88312253.3

**(22)** Date of filing : 22.12.88

**(54)** Dynamic random access memories having shared sensing amplifiers.

**(30)** Priority : **25.12.87 JP 328895/87**

**(43)** Date of publication of application :
05.07.89 Bulletin 89/27

**(45)** Publication of the grant of the patent :
03.05.95 Bulletin 95/18

**(84)** Designated Contracting States :
**DE FR GB NL**

**(56)** References cited :
**EP-A- 0 077 935**
**US-A- 4 656 613**

**(73)** Proprietor : **SONY CORPORATION**
**7-35 Kitashinagawa 6-chome**
**Shinagawa-ku**
**Tokyo 141 (JP)**

**(72)** Inventor : **Miyabayashi, Masayuki Patents**
**Division Sony Corp.**
**6-7-35, Kitashinagawa**
**Shinagawa-ku Tokyo 141 (JP)**
Inventor : **Takeshita, Kaneyoshi Patents**
**Division Sony Corp.**
**6-7-35, Kitashinagawa**
**Shinagawa-ku Tokyo 141 (JP)**

**(74)** Representative : **Thomas, Christopher Hugo et al**
**D. Young & Co,**
**21 New Fetter Lane**
**London EC4A 1DA (GB)**

## Description

This invention relates to dynamic random access memories having shared sensing amplifiers, in which sensing amplifiers are shared by two memory cell arrays.

A dynamic random access memory (DRAM) has been proposed having so-called shared sensing amplifiers, wherein the memory cell array controlled by one sensing amplifier is divided, and switch means provided between the memory cell arrays and the sensing amplifiers is switched to reduce the bit line capacity by one half to speed up and/or increase the sensitivity of the read-out and write operations. This is disclosed for example in Japanese patent publication 61/46918 (US patent specification US-A-4 366 559).

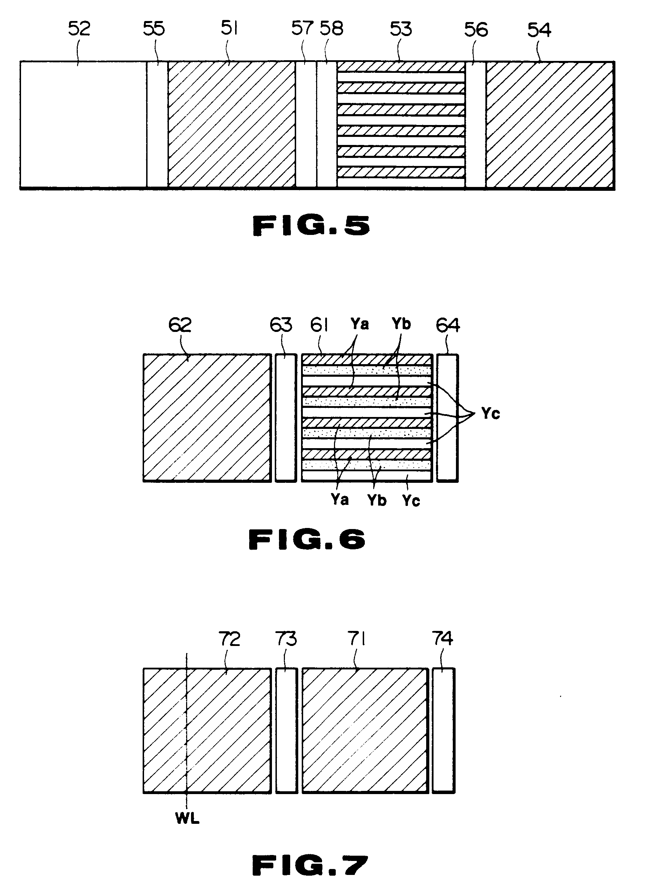

Figure 7 shows diagrammatically portions of a DRAM having these sensing amplifiers. There are provided first and second memory cell arrays 71 and 72, and sensing amplifiers 73 shared by the memory cell arrays 71 and 72, and associated with bit lines (not shown). An input/output (I/O) line 74 is provided on the side of the first memory cell array 71 opposite to the sensing amplifiers 73. Although not shown, switch means are provided on both sides of the sensing amplifiers 73.

Let us consider the read-out operation of this DRAM. When reading out data from a memory cell of the second memory cell array 72 remote from the I/O line 74, a word line WL is selected, and only the second memory cell array 72 is connected by the switch means to the sensing amplifiers 73 for signal amplification. At this time, the first memory cell array 71 and the sensing amplifiers 73 are not connected to each other. By bit line division, the read-out operation can be performed speedily and with high sensitivity. After signal amplification, read-out to the I/O line 74 is achieved via bit lines of the first memory cell array 71.

The technique of using these shared sensing amplifiers to take advantage of the bit line division is also described in Nikkei Micro-Device, separate volume No. 1, May 1987, "Full aspect of 4M DRAM, which is being put to practical usage", pages 104 to 106 and 260 to 261.

In this DRAM, when data are to be transferred from the I/O line 74, the bit lines of the first memory cell array 71 adjacent to the I/O line 74 are necessarily employed. For this reason, even when it is the memory cells of the second memory cell array 72 that are to be accessed, the bit lines of the first memory cell array 71 between the sensing amplifiers 73 and the I/O line 74 are necessarily charged and discharged, thus increasing the power consumption. Also, the bit lines to be charged or discharged extend across the two memory cell arrays 71 and 72, thus causing delay in the circuit operation.

EP-A-0 077 935 discloses a DRAM having sense amplifiers shared between two memory cell arrays and also between groups of bit line pairs in each memory cell array.

According to the present invention there is provided a DRAM having folded bit line-shared sensing amplifiers, said DRAM comprising:

first and second memory cell arrays;

a plurality of sensing amplifiers provided between and shared by said arrays;

input/output means provided on the side of said first array opposite to said sensing amplifiers;

a plurality of bit line pairs, each pair having connected therebetween a respective memory cell of said first array, a sensing amplifier, and a respective memory cell of said second array, said bit line pairs being divided into at least two groups of bit line pairs;

first switch means provided between said sensing amplifiers and said first array, said first switch means comprising a separate first group of switch means corresponding to each group of bit line pairs; and

second switch means provided between said sensing amplifiers and said second array;

characterised in that:

a respective sensing amplifier is provided for each bit line pair;

a said switch means of a said first group of switch means is provided for each bit line pair of the corresponding group of bit line pairs between said respective sensing amplifier and said respective first array memory cell of said bit line pair;

said second switch means comprises a common second group of switch means for said bit line pairs, a said switch means of said common second group being provided for each bit line pair between said respective sensing amplifier and said respective second array memory cell of each bit line pair; and

on accessing said second array, said switch means of said second group are operable in common for each bit line to connect said respective second array memory cell to said respective sensing amplifier, said switch means of a said first group of switch means are operable in common for the corresponding group of bit line pairs to connect via each bit line pair thereof said respective sensing amplifier to said input/output means, and said switch means for another said first group of switch means are operable in common for the corresponding group of bit line pairs to disconnect said respective sensing amplifiers from said input/output means.

According to the present invention there is also provided a DRAM having folded line-shared sensing amplifiers, said DRAM comprising a plurality of blocks; each block comprising:

first and second memory cell arrays;

a plurality of sensing amplifiers provided between and shared by said arrays;

input/output means provided on the side of said first array opposite to said sensing amplifiers;

a plurality of bit line pairs, each pair having connected therebetween a respective memory cell of said first array, a sensing amplifier, and a respective memory cell of said second array, said bit line pairs being divided into at least two groups of bit line pairs and a respective sensing amplifier being provided for each bit line pair;

first switch means provided between said sensing amplifiers and said first array, said first switch means comprising a separate first group of switch means corresponding to each group of bit line pairs, and a said switch means of a said first group of switch means being provided for each bit line pair of the corresponding group of bit line pairs between said respective sensing amplifier and said respective first array memory cell of said bit line pair; and

second switch means provided between said sensing amplifiers and said second array, said second switch means comprising a common second group of switch means for said bit line pairs, a said switch means of said common second group being provided for each bit line pair between said respective sensing amplifier and said respective second array memory cell of each bit line pair;

wherein on accessing said second array, said switch means of said second group are operable in common for each bit line pair to connect said respective second array memory cell to said respective sensing amplifier, said switch means of a said first group of switch means are operable in common for the corresponding group of bit line pairs to connect via each bit line pair thereof said respective sensing amplifier to said input/output means, and said switch means for another said first group of switch means are operable in common for the corresponding group of bit line pairs to disconnect said respective sensing amplifiers from said input/output means.

Thus embodiments of the invention provide a DRAM having folded bit line-shared sensing amplifiers, two memory cell arrays, I/O lines connected to the sensing amplifiers with the memory cell arrays in between, and switch means for controlling the connection and disconnection between the sensing amplifiers and the bit lines, wherein the switch means on the I/O line side are caused to operate so as to divide the bit lines into a plurality of bit line groups, whereas the switch means on the other side are grouped in common, thus reducing the power consumption caused by charging and discharging of the bit lines.

The invention will now be described by way of example with reference to the accompanying drawings, in which:

Figure 1 is a circuit diagram of an embodiment of DRAM according to the present invention;

Figure 2 is a diagrammatic view showing areas charged and discharged on accessing the first memory cell array of the DRAM of Figure 1;

Figure 3 is a diagrammatic view showing areas charged and discharged on accessing the second memory cell array of the DRAM of Figure 1;

Figure 4 is a time charge for illustrating the operation of the DRAM of Figure 1;

Figure 5 is a diagrammatic view of a modified embodiment;

Figure 6 is a diagrammatic view of another modified embodiment; and

Figure 7 is a diagrammatic view of a previously-proposed DRAM.

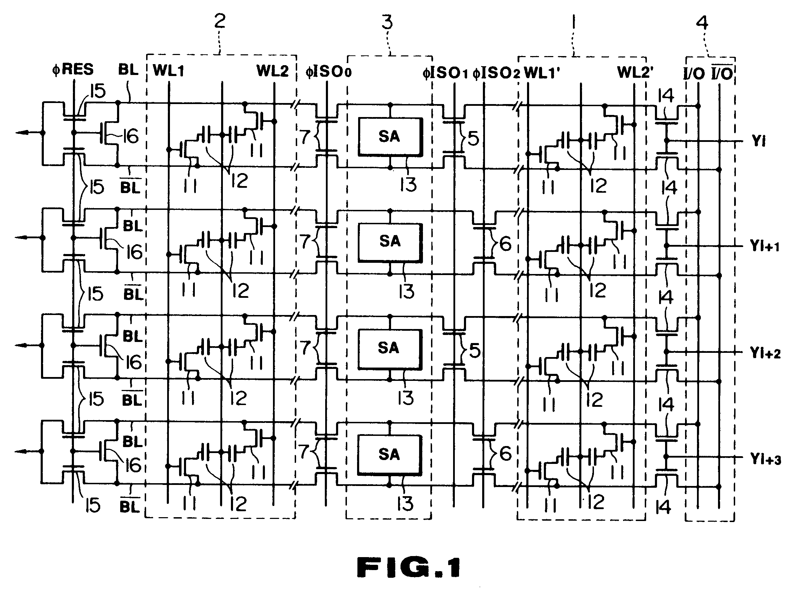

Referring to Figure 1, the first embodiment of DRAM (dynamic RAM) is formed by a first memory cell array 1 and a second memory cell array 2, each comprising a matrix of a plurality of memory cells, a sensing amplifier array 3 comprising a plurality of sensing amplifiers 13 provided between two memory cell arrays 1 and 2, and an I/O line pair 4 on the other side of the first memory cell array 1 relative to the sensing amplifier array 3. Transistors 5 and 6 forming first switch means are provided between the first memory cell array 1 and the sensing amplifier array 3, and a transistor 7 forming second switch means is provided between the sensing amplifier array 3 and the second memory cell array 2.

The memory cell arrays 1 and 2 are each formed by a matrix of memory cells, each of which is formed by an access transistor 11 and a capacitor 12. The gates of the access transistors 11 are connected to word lines WL1, WL2, ....., WL1', WL2', ..... . One of the source and the drain of each access transistor 11 is connected to a bit line BL and $\overline{BL}$, while the other of the source and the drain is connected to the capacitor 12. The bit lines BL and $\overline{BL}$ are paired. In Figure 1, the bit line pairs for the column numbers i to i+3 are shown for simplicity. These bit line pairs are selected by the turning on and off of column selection transistors 14 fed with column selection signals.

The sensing amplifiers 13 making up the sensing amplifier array 3 are provided between the memory cell arrays 1 and 2, so that each sensing amplifier 13 is associated with one bit line pair BL and $\overline{BL}$. The sensing amplifiers 13 are shared by the memory cell arrays 1 and 2, and operate to amplify the differential signal between the bit lines BL and $\overline{BL}$ extending across the memory cell arrays 1 and 2. That is, the sensing amplifiers 13 are so-called shared sensing amplifiers and, by the transistors 5, 6 and 7 of the first and second switching means as later described, divide the bit line pairs BL and $\overline{BL}$ extending across the memory cell arrays 1 and 2.

The I/O line pair 4 is provided on the opposite side of the first memory cell array 1 from the sensing amplifier array 3. The I/O line pair 4, adjacent to the first memory cell array 1, is formed by an I/O line and an I/O line. The I/O line is connected via column selection transistors 14 to the bit line BL, while the I/O line is connected via column selection transistors 14 to the bit line $\overline{BL}$. Data transfer is performed via the I/O line pair 4.

The transistors 5 and 6 forming the first switch means electrically connect or disconnect the bit lines BL and $\overline{BL}$ between the first memory cell array 1 and the sensing amplifiers 13. The transistors 5 are connected in series with the paired bit lines selected by column selection signals $Y_i$, $Y_{i+2}$, ..... . To the gate of each of the transistors 5 is supplied a switching signal $\emptyset ISO_1$, such that, when the switching signal $\emptyset ISO_1$ is at an H (high) level, the bit lines BL and $\overline{BL}$ and the associated sensing amplifier 13 are connected to each other and, when the switching signal $\emptyset ISO_1$ is at an L (low) level, the bit lines BL and $\overline{BL}$ and the sensing amplifier 13 are disconnected from each other. The transistors 6 forming the first switch means are connected in series with paired bit lines selected by column selection signals $Y_{i+1}$, $Y_{i+3}$, ..... . Thus the bit columns controlled by the transistors 5 and the bit columns controlled by the transistors 6 are arrayed alternately, and the bit lines BL and $\overline{BL}$ are divided into a bit line group selected by the transistors 6 and a bit line group selected by the transistors 6. To the gate of each transistor 6 is supplied a switching signal $\emptyset ISO_2$, such that, when the switching signal $\emptyset ISO_2$ is H, the bit lines BL and $\overline{BL}$ and the associated sensing amplifier 13 are connected to each other, and when the switching signal $\emptyset ISO_2$ is L, the bit lines BL and $\overline{BL}$ and the associated sensing amplifier 13 are disconnected from each other.

The transistors 7 of the second switch means are provided in the bit lines BL and $\overline{BL}$ between the sensing amplifier array 3 and the memory cell array 2. To the gates of the transistors 7 is supplied a switching signal $\emptyset ISO_0$, such that, when the switching signal $\emptyset ISO_0$ is H, the transistors 7 are turned on and, when the switching signal $\emptyset ISO_0$ is L, the transistors 7 are turned off.

On the side of the second memory cell array 2 opposite to the sensing amplifiers 13, transistors 15 and 16 forming a bit line loading circuit and an equalizer circuit are provided, and are controlled by a signal $\emptyset RES$.

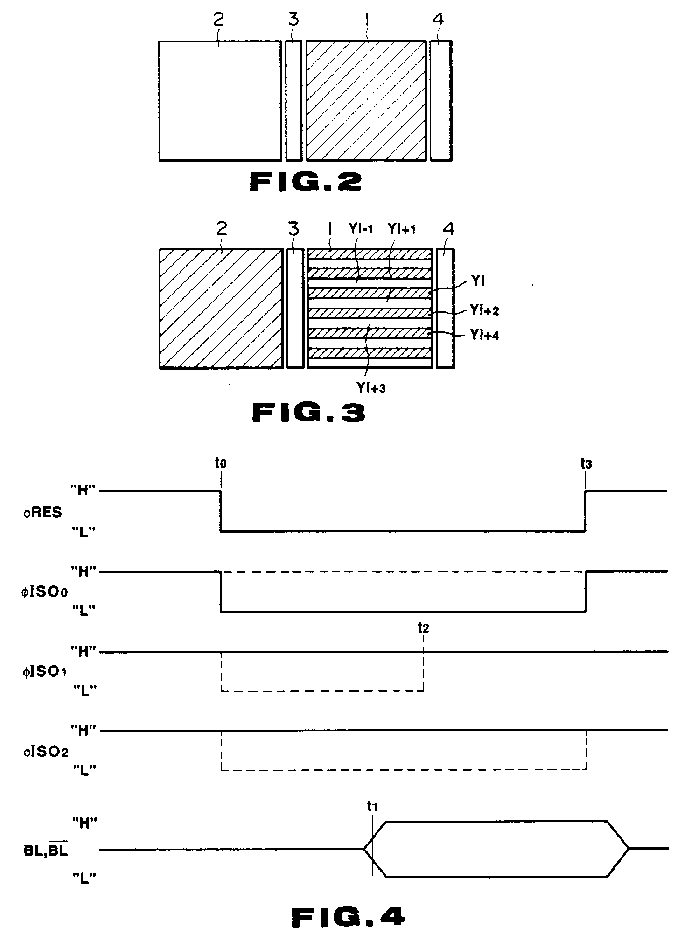

Referring to Figures 2 to 4, the case of accessing the first memory cell array 1, and then the case of accessing the second memory cell array 2 will be explained.

When accessing the first memory cell array 1, the signal $\emptyset RES$ goes at time $t_0$ to L, while the signal $\emptyset ISO_0$ also goes to L, as indicated by solid lines in Figure 4. The transistors 15 and 16 are turned off, the transistors 7 of the second switch means also being turned off. The signals $\emptyset ISO_1$ and $\emptyset ISO_2$ are both H, so that the transistors 5 and 6 are turned on. Thus the sensing amplifiers 13 are connected via the bit lines BL and $\overline{BL}$ only with the first memory cell array 1. After such activation of the first and second switch means, one of the word lines WL1', WL2', ..... is selected by column address signals. Then, at time $t_1$, by the sensing operation of the sensing amplifier 13, the potentials of the bit lines BL and $\overline{BL}$ are amplified to H and L, respectively, in dependence on the data of the selected memory cell. Since the transistor 7 is turned off, and the transistors 5 and 6 are turned on, the parts of the bit lines BL and $\overline{BL}$ that are charged and discharged at this time are only those areas extending over the first memory cell array 1, as shown in Figure 2. The areas of the bit lines BL and $\overline{BL}$ extending over the second memory cell array 2 are not charged or discharged.

One of the column selection signals $Y_i$, $Y_{i+3}$, ..... goes to H, and only the bit line pair associated with the selected column is connected to the I/O line pair 4 to permit data reading and writing. Restoration is performed only with respect to the first memory cell 1 with the bit lines BL and $\overline{BL}$ of the second memory cell array 2 not being charged or discharged. At time $t_3$, the signal $\emptyset RES$ is changed from L to H, while the signal $\emptyset ISO_0$ is changed from L to H.

When accessing the second memory cell array 2, the signal $\emptyset RES$ goes to L at time $t_0$, as shown in Figure 4, while the signal $\emptyset ISO_0$ remains at H, as shown by a dashed line in Figure 4. At this time $t_0$, the signals $\emptyset ISO_1$, and $\emptyset ISO_2$ controlling the transistors 5 and 6 are changed from H to L, as shown by dashed lines in Figure 4, so that the transistors 5 and 6 are turned off. Hence, only the second memory cell array 2 is connected via the bit lines BL and $\overline{BL}$ to the sensing amplifiers 13. After such activation of the first and second switch means, one of the word lines WL1, WL2, ..... is selected by the column address signals. Then, at time $t_1$, by the sensing operation of the sensing amplifier 13, the potentials of the bit lines BL and $\overline{BL}$ are amplified to H and L, respectively, in dependence on the data of the selected memory cell. Since the transistor 7 is turned on and the transistors 5 and 6 are turned off, the parts of the bit lines BL and $\overline{BL}$ that are charged or discharged are limited to areas of the second memory cell array 2.

The data of the selected memory cell are amplified by such activation of the sensing amplifiers 13. However, during reading or writing, it is necessary to turn the transistors 5 or 6 on selectively depending on the position of the accessed memory cell to connect the transistor 5 or 6 to the I/O lines. When accessing a memory cell associated with the bit lines BL and $\overline{BL}$ selected by, for example, the selection signals $Y_i$, $Y_{i+2}$, ....., the signal $\emptyset ISO_1$ is changed at time $t_2$ from L to H, as shown by a dashed line in Figure 4. Only the one bit line pair of the bit lines BL and $\overline{BL}$ extending into the first memory cell array 1, which is selected by the column selection signals $Y_i$, $Y_{i+2}$, ..... is connected with the sensing amplifier 13 via the transistor 5. Since the signal $\emptyset ISO_2$ remains at L, the transistor 6 remains off. Thus a memory cell on a column associated with the transistors 5, that is, a column selected by the column selection signals $Y_i$, $Y_{i+2}$, ..... is connected by the bit lines BL and $\overline{BL}$ with the I/O lines. Figure 3 shows by hatched lines the bit line areas charged and discharged at this time. In the conventional practice, it has been necessary to charge and discharge all the bit lines extending all over the first memory cell array 1 at the time the memory cells of the second memory cell array 2 are selected, whereas, in the present embodiment, only one half the bit lines extending over the first memory cell array 1 are charged or discharged. In addition, the bit lines are divided into two groups, so that when accessing the second memory cell 2, it is three-fourths of the overall area that is charged or discharged, whereas one-fourth of the overall area is not charged or discharged, so that the power consumption can be reduced.

When accessing the memory cells associated with the other transistors 6, it suffices to change the signal $\emptyset ISO_2$ at time $t_2$ from L to H, with the signal $\emptyset ISO_1$, remaining at L.

At time $t_3$, the signal $\emptyset RES$ is changed from L to H, while the signal $\emptyset ISO_2$ or $\emptyset ISO_1$ is changed from L to H.

In the above described operation of the embodiment, when access is had to a memory cell of the second memory cell array 2, only one half of the bit lines extended into the first memory cell array 1 are used, so that the other half of the bit lines of the first memory cell array 1 are not charged or discharged. Hence, the power consumption is reduced, while high speed operation is simultaneously achieved.

A second embodiment of DRAM is so arranged that the number of the memory cell arrays, that is, the number of blocks, is double that of the DRAM of the preceding embodiment, with the control being made to provide for a constant power consumption.

Referring to Figure 5, the DRAM shown therein is formed by two blocks, there being four memory cell arrays 51, 52, 53 and 54, there being a sensing amplifier array 55 between the memory cell arrays 51 and 52 and a sensing amplifier array 56 between the memory cell arrays 53 and 54. I/O line pairs 57 and 58 are provided between the memory cell arrays 51 and 53, so that the memory cell arrays 51 and 53 represent the first memory cell array having first switch means for dividing the bit lines into a plurality of groups.

In the present DRAM wherein the number of memory cell arrays is twice that in the DRAM of the preceding embodiment, when one of the two blocks on respective sides of the I/O line pairs 57 and 58 is accessing the first memory cell array, the second memory cell array in the other block is accessed simultaneously. In Figure 5, the areas shown by the hatched lines are those areas undergoing charging and discharging. For example, the memory cell arrays 51 and 54 have memory cells being accessed, and the bit lines divided during the operation are only those associated with the memory cell array 53. As shown, it is five-eights of the overall area that undergoes charging or discharging, so that the power consumption is again reduced.

In the present embodiment, when the first memory cell array is accessed in one of the blocks, the second memory cell array is accessed in the other block. Thus the block controlled by the solid line and the block controlled by the dashed line in Figure 4 are contiguous to each other. In this manner, the hatched line area in Figure 5 remains constant at all times, with the figure of five-eighth not being changed.

The number of the blocks is not limited to two, and a similar control operation can be performed with respect to a larger number of blocks.

In a third embodiment, the bit lines are divided into three bit line groups.

Referring to Figure 6, the bit lines in a first memory cell array 61 are divided into a group of bit columns Ya, a group of bit columns Yb and a group of bit columns Yc. A sensing amplifier array 63 is provided between the first memory cell array 61 and a second memory cell array 62, and an I/O line pair 64 is provided on the other side of the first memory cell array 61 from the sensing amplifier array 63. Although not shown, first and second switch means are provided, with three signals being controlled by the first switch means.

In this DRAM, only one of the three bit line group Ya, Yb and Yc undergoes charging or discharging during accessing of the second memory cell array 62. It is the bit line group associated with the bit lines BL and $\overline{BL}$ associated in turn with the accessed memory cells that is selected.

In the above construction, the power consumption can be reduced, while the speeding up of the operation is simultaneously achieved.

The bit lines may be divided into four or more groups instead of three.

## Claims

1. A DRAM having folded bit line-shared sensing amplifiers (13), said DRAM comprising:

    first and second memory cell arrays (1, 2);

    a plurality of sensing amplifiers (13) provided between and shared by said arrays (1, 2);

    input/output means (4) provided on the side of said first array (1) opposite to said sensing amplifiers (13);

    a plurality of bit line pairs (BL, $\overline{BL}$), each pair having connected therebetween a respective memory cell of said first array (1), a sensing amplifier (13), and a respective memory cell of said second array (2), said bit line pairs being divided into at least two groups of bit line pairs;

first switch means (5,6) provided between said sensing amplifiers and said first array, said first switch means comprising a separate first group of switch means corresponding to each group of bit line pairs; and

second switch means (7) provided between said sensing amplifiers and said second array;

characterised in that:

a respective sensing amplifier (13) is provided for each bit line pair;

a said switch means (5/6) of a said first of switch means is provided for each bit line pair of the corresponding group of bit line pair between said respective sensing amplifier and said respective first array memory cell of said bit line pair;

said second switch means comprises a common second group of switch means (7) for said bit line pairs, a said switch means (7) of said common second group being provided for each bit line pair between said respective sensing amplifier and said respective second array memory cell of each bit line pair; and

on accessing said second array, said switch means (7) of said second group are operable in common for each bit line pair to connect said respective second array memory cell to said respective sensing amplifier, said switch means (5) of a said first group of switch means are operable in common for the corresponding group of bit line pairs to connect via each bit line pair thereof said respective sensing amplifier to said input/output means, and said switch means (6) for another said first group of switch means are operable in common for the corresponding group of bit line pairs to disconnect said respective sensing amplifiers from said input/output means.

2. A DRAM according to claim 1 wherein said first switch means (5, 6) divides said bit line pairs (BL, $\overline{BL}$ alternately into two bit line pair groups for said first array (1).

3. A DRAM having folded line-shared sensing amplifiers (13), said DRAM comprising a plurality of blocks; each block comprising:

first and second memory cell arrays (1, 2);

a plurality of sensing amplifiers (13) provided between and shared by said arrays (1, 2);

input/output means (4) provided on the side of said first array (1) opposite to said sensing amplifiers (13);

a plurality of bit line pairs (BL, $\overline{BL}$), each pair having connected therebetween a respective memory cell of said first array (1), a sensing amplifier (13), and a respective memory cell of said second array (2), said bit line pairs being divided into at least two groups of bit line pairs and a respective sensing amplifier (13) being provided for each bit line pair;

first switch means (5,6) provided between said sensing amplifiers and said first array, said first switch means comprising a separate first group of switch means corresponding to each group of bit line pairs, a said switch means (5/6) of a said first group of switch means being provided for each bit line pair of the corresponding group of bit line pairs between said respective sensing amplifier and said respective first array memory cell of said bit line pair; and

second switch means (7) provided between said sensing amplifiers and said second array, said second switch means comprising a common second group of switch means (7) for said bit line pairs, a said switch means (7) of said common second group being provided for each bit line pair between said respective sensing amplifier and said respective second array memory cell of each bit line pair;

wherein, on accessing said second array, said switch means (7) of said second group are operable in common for each bit line pair to connect said respective second array memory cell to said respective sensing amplifier, and said switch means (5) of a said first group of switch means are operable in common for the corresponding group of bit line pairs to connect via each bit line pair thereof said respective sensing amplifier to said input/output means, and said switch means (6) for another said first group of switch means are operable in common for the corresponding group of bit line pairs to disconnect said respective sensing amplifiers from said input/output means.

4. A DRAM according to claim 3 wherein:

said blocks are divided into one block or blocks and another block or blocks, said first switch means (5, 6) dividing the bit line pairs (BL, $\overline{BL}$) into a first bit line pair group and a second bit line pair group for said first array (1); and

during accessing, said first array (1) is accessed in said one block or blocks at the same time that said second array (2) is accessed in the other block or blocks.

**Patentansprüche**

1. DRAM, der gefaltete, anteilig bitleitungsgenutzte Abtastverstärker (13) hat, wobei der DRAM aufweist:

eine erste und zweite Speicherzellenreihe (1, 2);

mehrere Abtastverstärker (13), die dazwischen vorgesehen sind und durch die Reihen (1, 2) anteilig genutzt werden;

eine Eingabe/Ausgabeeinrichtung (4), die auf der Seite der ersten Reihe (1) gegenüber den Abtastverstärkern (13) angeordnet ist;

mehrere Bitleitungspaare (BL, $\overline{BL}$), wobei zwischen jedem Paar eine entsprechende Speicherzelle der ersten Reihe (1), ein Abtastverstärker (13) und eine entsprechende Speicherzelle der zweiten Reihe (2) geschaltet ist, wobei die Bitleitungspaare in zumindest zwei Bitleitungspaar-Gruppen aufgeteilt sind;

eine erste Schalteinrichtung (5, 6), die zwischen den Abtastverstärkern und der ersten Reihe vorgesehen ist, wobei die erste Schalteinrichtung eine separate erste Schalteinrichtungsgruppe entsprechend jeder Bitleitungspaar-Gruppe aufweist; und

eine zweite Schalteinrichtung (7), die zwischen den Abtastverstärkern und der zweiten Reihe vorgesehen ist;

dadurch gekennzeichnet, daß:

ein entsprechender Abtastverstärker (13) für jedes Bitleitungspaar vorgesehen ist;

die eine genannte Schalteinrichtung (5, 6) der ersten Schalteinrichtungsgruppe für jedes Bitleitungspaar der entsprechenden Bitleitungspaar-Gruppe zwischen dem entsprechenden Abtastverstärker und der entsprechenden ersten Reihenspeicherzelle des Bitleitungspaars vorgesehen ist;

die zweite Schalteinrichtung eine gemeinsame zweite Schalteinrichtungsgruppe (7) für die Bitleitungspaare aufweist, wobei die eine genannte Schalteinrichtung der gemeinsamen zweiten Gruppe für jedes Bitleitungspaar zwischen dem entsprechenden Abtastverstärker und der entsprechenden zweiten Reihenspeicherzelle jedes Bitleitungspaars vorgesehen ist; und

beim Zugriff auf die zweite Reihe die genannte Schalteinrichtung (7) der zweiten Gruppe gemeinsam für jedes Bitleitungspaar so betreibbar ist, daß sie die entsprechende zweite Reihenspeicherzelle mit dem entsprechenden Abtastverstärker verbindet, wobei die Schalteinrichtung (5) der genannten ersten Schalteinrichtungsgruppe gemeinsam für die entsprechende Bitleitungspaar-Gruppe so betreibbar ist, daß sie über jedes Bitleitungspaar davon den entsprechenden Abtastverstärker mit der Eingabe/Ausgabeeinrichtung verbindet, und daß die Schalteinrichtung (6) für die andere erste Schalteinrichtungsgruppe gemeinsam für die entsprechende Bitleitungspaar-Gruppe so betreibbar ist, daß sie die entsprechenden Abtastverstärker von der Eingabe/Ausgabeeinrichtung trennt.

2. DRAM nach Anspruch 1, wobei die erste Schalteinrichtung (5, 6) die Bitleitungspaare (BL, $\overline{BL}$) abwechselnd in zwei Bitleitungspaar-Gruppen für die erste Reihe (1) unterteilt.

3. DRAM, der gefaltete anteilig bitleitungsgenutzte Abtastverstärker (13) hat, wobei der DRAM mehrere Blöcke aufweist, wobei jeder Block umfaßt:

eine erste und zweite Speicherzellenreihe (1, 2);

mehrere Abtastverstärker (13), die dazwischen vorgesehen sind und die durch die Reihen (1, 2), anteilig genutzt werden;

eine Eingabe/Ausgabeeinrichtung (4), die auf der Seite der ersten Reihe (1) gegenüber den Abtastverstärkern (13 vorgesehen ist;

mehrere Bitleitungspaare (BL, $\overline{BL}$), wobei zwischen jedem Paar eine entsprechende Speicherzelle der ersten Reihe (1), ein Abtastverstärker (13) und eine entsprechende Speicherzelle der zweiten Reihe (2) geschaltet ist, wobei die Bitleitungspaare in zumindest zwei Bitleitungspaar-Gruppen aufgeteilt sind und ein entsprechender Abtastverstärker (13) für jedes Bitleitungspaar vorgesehen ist;

eine erste Schalteinrichtung (5, 6), die zwischen den Abtastverstärkern und der ersten Reihe vorgesehen ist, wobei die erste Schalteinrichtung eine separate erste Schalteinrichtungsgruppe entsprechend jeder Bitleitungspaar-Gruppe aufweist, wobei die eine genannte Schalteinrichtung (5, 6) der ersten Schalteinrichtungsgruppe für jedes Bitleitungspaar der entsprechenden Bitleitungspaar-Gruppe zwischen dem entsprechenden Abtastverstärker und der entsprechenden ersten Reihenspeicherzelle des Bitleitungspaars vorgesehen ist; und

eine zweite Schalteinrichtung (7), die zwischen den Abtastverstärkern und der zweiten Reihe vorgesehen ist, wobei die zweite Schalteinrichtung eine gemeinsame zweite Schalteinrichtungsgruppe (7) für die Bitleitungspaare aufweist, wobei die genannte eine Schalteinrichtung (7) der gemeinsamen zweiten Gruppe für jedes Bitleitungspaar zwischen dem entsprechenden Abtastverstärker und der entsprechenden zweiten Reihenspeicherzelle jedes Bitleitungspaars vorgesehen ist;

wobei beim Zugriff auf die zweite Reihe die Schalteinrichtung (7) der zweiten Gruppe gemeinsam für jedes Bitleitungspaar so betreibbar ist, daß sie die entsprechende Reihenspeicherzelle mit dem entsprechenden Abtastverstärker verbindet, und wobei die Schalteinrichtung (5) der ersten Schalteinrichtungsgruppe gemeinsam für die entsprechende Bitleitungspaar-Gruppe so betreibbar ist, daß sie über jedes Bitleitungspaar davon den entsprechenden Abtastverstärker mit der Eingabe/Ausgabeeinrichtung verbindet, und wobei die Schalteinrichtung (6) für die andere erste Schalteinrichtungsgruppe gemeinsam für die entsprechende Bitleitungspaar-Gruppe so betreibbar ist, daß sie die entsprechenden Abtastverstärker von der Eingabe/Ausgabeeinrichtung trennt.

4. DRAM nach Anspruch 3, wobei:
die Blöcke in einen Block oder Blöcke und einen anderen Block oder Blöcke aufgeteilt sind, wobei die erste Schalteinrichtung (5, 6) die Bitleitungspaare (BL, $\overline{BL}$) in erste Bitleitungspaargruppe und eine zweite Bitleitungspaargruppe für die erste Reihe (1) unterteilt; und
während des Zugriffs auf die erste Gruppe (1) in einem Block oder Blöcke im gleichen Zeitpunkt zugegriffen wird, wo auf die zweite Reihe (2) im anderen Block oder in den Blöcken zugegriffen wird.

**Revendications**

1. Mémoire DRAM ayant des amplificateurs de détection de lignes binaires partagés et repliés (13), ladite mémoire DRAM comprenant :
des premier et second réseaux de cellules de mémoire (1, 2) ;
une pluralité d'amplificateurs de détection (13) placés entre et partagés par lesdits réseaux (1, 2) ;
un dispositif d'entrée/sortie (4) placé du côté dudit premier réseau (1) opposé auxdits amplificateurs de détection (13) ;
une pluralité de paires de lignes binaires (BL, $\overline{BL}$) chaque paire ayant raccordé entre elles une cellule de mémoire respective dudit premier réseau (1), un amplificateur de détection (13), et une cellule de mémoire respective dudit second réseau (2), lesdites paires de lignes binaires étant divisées en au moins deux groupes de paires de lignes binaires ;
un premier dispositif de commutation (5, 6) placé entre lesdits amplificateurs de détection et ledit premier réseau, ledit premier dispositif de commutation comprenant un premier groupe séparé de dispositifs de commutation correspondant à chaque groupe de paires de lignes binaires ; et
un second dispositif de commutation (7) placé entre lesdits amplificateurs de détection et ledit second réseau ;
caractérisé en ce que :
un amplificateur de détection respectif (13) est fourni pour chaque paire de lignes binaires ;
ledit dispositif de commutation (5/6) dudit premier groupe de dispositifs de commutation est fourni pour chaque paire de lignes binaires du groupe correspondant de paires de lignes binaires entre ledit amplificateur de détection respectif et ladite cellule de mémoire respective du premier réseau de ladite paire de lignes binaires ;
ledit second dispositif de commutation comprend un second groupe commun de dispositifs de commutation (7) pour lesdites paires de lignes binaires, ledit dispositif de commutation (7) dudit second groupe commun étant fourni pour chaque paire de lignes binaires entre ledit amplificateur de détection respectif et ladite cellule de mémoire respective du second réseau de chaque paire de lignes binaires ; et
lors de l'accès audit second réseau, lesdits dispositifs de commutation (7) dudit second groupe sont utilisables en commun pour chaque paire de lignes binaires pour relier lesdites cellules de mémoire respectives du second réseau audit amplificateur de détection respectif, lesdits dispositifs de commutation (5) dudit premier groupe de dispositifs de commutation sont utilisables en commun pour le groupe correspondant des paires de lignes binaires pour relier via chaque paire de lignes binaires de celui-ci ledit amplificateur de détection respectif audit dispositif d'entrée/sortie, et lesdits dispositifs de commutation (6) pour un autre dit premier groupe de dispositifs de commutation sont utilisables en commun pour le groupe correspondant des paires de lignes binaires pour déconnecter lesdits amplificateurs de détection respectifs dudit dispositif d'entrée/sortie.

2. Mémoire DRAM selon la revendication 1 dans laquelle ledit premier dispositif de commutation (5, 6) divise alternativement lesdites paires de lignes binaires (BL, $\overline{BL}$) en deux groupes de paires de lignes binaires pour ledit premier réseau (1).

3. Mémoire DRAM ayant des amplificateurs de détection de lignes binaires partagés et repliés (13), ladite mémoire DRAM comprenant une pluralité de blocs, chaque bloc comprenant :
des premier et second réseaux de cellules de mémoire (1, 2) ;
une pluralité d'amplificateurs de détection (13) placés entre et partagés par lesdits réseaux (1, 2) ;
un dispositif d'entrée/sortie (4) placé du côté dudit premier réseau (1) opposé auxdits amplificateurs de détection (13) ;
une pluralité de lignes binaires (BL, $\overline{BL}$), chaque paire ayant raccordé entre elles une cellule de mémoire respective dudit premier réseau (1), un amplificateur de détection (13), et une cellule de mémoire respective dudit second réseau (2), lesdites paires de lignes binaires étant divisées en au moins deux groupes de paires de lignes binaires et un amplificateur de détection respectif (13) étant fourni pour chaque paire de lignes binaires ;

un premier dispositif de commutation (5, 6) placé entre lesdits amplificateurs de détection et ledit premier réseau, ledit premier dispositif de commutation comprenant un premier groupe séparé de dispositifs de commutation correspondant à chaque groupe de paires de lignes binaires, ledit dispositif de commutation (5/6) dudit premier groupe de dispositifs de commutation étant fourni pour chaque paire de lignes binaires du groupe correspondant de paires de lignes binaires entre ledit amplificateur de détection respectif et ladite cellule de mémoire respective du premier réseau desdites paires de lignes binaires ; et

un second dispositif de commutation (7) placé entre lesdits amplificateurs de détection et ledit second réseau, ledit second dispositif de commutation comprenant un second groupe commun de dispositifs de commutation (7) pour lesdites paires de lignes binaires, ledit dispositif de commutation (7) dudit second groupe commun étant fourni pour chaque paire de lignes binaires entre ledit amplificateur de détection respectif et ladite cellule de mémoire respective du second réseau de chaque paire de lignes binaires ;

dans laquelle, lors de l'accès audit second réseau, lesdits dispositifs de commutation (7) dudit second groupe sont utilisables en commun pour chaque paire de lignes binaires pour relier ladite cellule de mémoire respective du second réseau audit amplificateur de détection respectif et, lesdits dispositifs de commutation (5) dudit premier groupe de dispositifs de commutation sont utilisables en commun pour le groupe correspondant de paires de lignes binaires pour relier via chaque paire de lignes binaires de celui-ci ledit amplificateur de détection respectif audit dispositif d'entrée/sortie, et lesdits dispositifs de commutation (6) pour un autre dit premier groupe de dispositifs de commutation sont utilisables en commun pour le groupe correspondant des paires de lignes binaires pour déconnecter lesdits amplificateurs de détection respectifs dudit dispositif d'entrée/sortie.

4. Mémoire DRAM selon la revendication 3 dans laquelle :

lesdits blocs sont divisés en un bloc ou des blocs et en un autre bloc ou des autres blocs, ledit premier dispositif de commutation (5, 6) divisant les paires de lignes binaires (BL, $\overline{BL}$) en un premier groupe de paires de lignes binaires et en un second groupe de paires de lignes binaires pour ledit premier réseau (1) ; et

lors de l'accès, on accède audit premier réseau (1) dans ledit bloc ou lesdits blocs au même instant où on accède audit second réseau (2) dans l'autre bloc ou les autres blocs.

FIG.1

## FIG.2

## FIG.3

## FIG.4

52  55  51  57 58  53  56  54

**FIG.5**

62  63  61  Ya  Yb  64

Yc

Ya  Yb  Yc

**FIG.6**

72  73  71  74

WL

**FIG.7**